# EUROPEAN PATENT SPECIFICATION

(11) **EP 0 559 153 B1**
(45) Date of publication and mention of the grant of the patent: **10.09.1997**
(21) Application number: 93103315.3
(22) Date of filing: 02.03.1993
(51) Int. Cl.: G03F 7/30

(54) **Plate-making method of dry lithographic plate and plate-making apparatus**
Verfahren zur Herstellung einer Druckform für den wasserlosen Flachdruck und Gerät zur Herstellung einer Druckform
Procédé pour la fabrication d'une plaque d'impression pour la lithographie à sec et appareil de fabrication de plaques d'impression

(30) Priority: 03.03.1992 JP 45674/92
(43) Date of publication of application: 08.09.1993
(73) Proprietor: Fuji Photo Film Co., Ltd., Kanagawa-ken (JP)
(72) Inventor: Yoshida, Susumu, c/o FUJI PHOTO FILM CO., LTD., Haibara-gun, Shizuoka-ken (JP)
(74) Representative: Grünecker, Kinkeldey, Stockmair & Schwanhäusser Anwaltssozietät

(56) References cited:
- EP-A- 0 346 921
- EP-A- 0 383 314
- WO-A-90/02975
- GB-A- 2 232 503
- US-A- 4 222 656
- US-A- 4 588 277
- DATABASE WPIL Week 9144, Derwent Publications Ltd., London, GB; AN 91-320787 & JP-A-3 213 861 (KONICA CORP.) 19 September 1991
- PATENT ABSTRACTS OF JAPAN vol. 12, no. 483 (P-802)(3330) 16 December 1988 & JP-A-63 197 951 ( KONICA CORP. ) 16 August 1988
- DATABASE WPIL Derwent Publications Ltd., London, GB; AN 83-805350 & JP-A-58 162 392 (MITSUBISHI PAPER MILL) 27 September 1983
- DATABASE WPIL Week 9144, Derwent Publications Ltd., London, GB; AN 91-320789 & JP-A-3 213 863 (KONICA CORP.) 19 September 1991
- PATENT ABSTRACTS OF JAPAN vol. 12, no. 488 (P-803)(3335) 20 December 1988 & JP-A-63 200 153 ( KONICA CORP ) 18 September 1988

## Description

The present invention relates to a plate-making method for preparing a lithographic printing plate requiring no dampening water (hereinafter referred to as "dry lithographic plate"), in which an imagewise-exposed presensitized plate for use in making a lithographic printing plate requiring no dampening water (hereinafter referred to as "dry PS plate") is developed with a processing solution substantially comprising water.

As dry PS plates comprising silicone rubber layers as ink-repellent layers, there have been proposed dry PS plates each comprising a substrate provided thereon with a photolytically solubilized or photolytically insolubilized light-sensitive layer and a silicone rubber layer as disclosed in JP-B-44-23042 and JP-B-46-16044; and dry PS plates each comprising a substrate provided thereon with a photoadhesive light-sensitive layer and a silicone rubber layer as disclosed in JP-A-48-94504 and JP-A-50-50102. The lithographic printing plates prepared from these dry PS plates permit the duplication of several tens of thousand copies without using any dampening water.

The foregoing dry PS plates each comprises a substrate of, for instance, aluminum and a light-sensitive layer and a silicone rubber layer put on the substrate in layers and the top surface thereof is laminated with a protective film to protect the surface thereof. If the dry PS plate is imagewise exposed to light, the light-sensitive layer in the light-exposed area is hardened depending on the intensity of exposure and correspondingly the adhesion of the imagewise-exposed light-sensitive layer to the silicone rubber layer increases. If a developer is applied onto the surface thereof at this stage, the silicone rubber layer on the unexposed area is peeled off. This is detailed in JP-B-54-26923.

Incidentally, there has been proposed the use of a processing solution consisting essentially of water (hereinafter referred to as "developing water") and free of substances included in the usual developers such as organic solvents, surfactants, basic substances and acidic substances, as a developer for the development of an imagewise-exposed dry PS plate (Japanese Patent Application Serial (hereinafter referred to as "J.P.A.") No. Hei 3-95581). This is because the quality of the dry PS plate has substantially been improved and accordingly, it has likewise been able to be developed with a developer free of substances included in the usual developer.

The developing treatment with such a developing water is quite favorable from the viewpoint of environmental protection since the use of developing water is safe and does not accompany the formation of any waste liquor. However, the developing water must be warmed to a temperature of 25 to 70 °C to ensure a proper developing ability thereof. Moreover, the silicone rubber layer on the unexposed area is removed during the development of a dry PS plate and correspondingly scum comprising silicone rubber removed from the dry PS plate is accumulated in the developing zone of an automatic developing machine. To use an automatic developing machine having great practical utility over a long time without exchanging the developing water, it is thus desirable to prevent any accumulation, in the developing water, of scum comprising the removed silicone rubber, any contamination of the processed dry PS plate and any decomposition of the developing water by continuously supplementing fresh developing water while draining excess developing water through overflow. In winter, in particular, in a cold district, however, the use of a heater having a high capacity is required for maintaining the temperature of the developing water to 25 to 70°C and continuously supplementing fresh developing water while draining excess developing water. This, in turn, requires the use of large-scale electric facilities and developing machines and this further makes the processing noneconomic because of an increase of energy charge.

GB-A-2232503 discloses a developing machine for both negative and positive photosensitive films comprising a warm water-dipping section and a brush-developing section.

JP-A-3213861 discloses the development of a dry PS plate. An imagewise-exposed presensitized plate is developed by 45°C warm water while rubbing with a sponge so that the unexposed part of the silicone rubber layer is removed completely, and more than 99% of dots are reproduced.

JP-A-63197951 discloses a method for processing a photographic material.

JP-A-58162392 discloses an anticorrosion treating solution for printing plates, said solution containing an antibacterial organic compound and triethylenetetramine hexaacetic acid or its salt.

EP-A-383314 discloses a processing apparatus for developing a waterless presensitized lithographic printing plate.

US-A-4588277 discloses an apparatus for processing plates for waterless lithographic printing.

Accordingly, an object of the present invention is to provide a method for preparing a dry lithographic plate, which permits the development of a dry PS plate with a processing solution consisting essentially of water using an automatic developing machine having great practical utility without using a heater having a high capacity and which is economical and favorable from the viewpoint of environmetal protection.

Another object of the present invention is to provide a plate-making apparatus suitable for practicing the foregoing plate-making method.

The foregoing object of the present invention can be accomplished by providing a method for making a lithographic printing plate requiring no dampening water using an automatic developing machine, said method comprising the steps of pre-treating an image-wise exposed presensitized plate for use in making a lithographic printing plate requiring no dampening water in a pre-treatment zone using a warm processing solution of from 25 to 70°C stored and circulated in said zone and filtered to remove any solid formed in the warm processing solution to maintain a water content of not less than 98%, and then removing the silicone rubber while sprinkling a developer having a water content of not less than 98%.

Moreover, the present invention provides a plate-making apparatus for developing an imagewise-exposed presensitized plate for use in making a lithographic printing plate requiring no dampening water which comprises:
a pre-treatment zone for pre-treating the imagewise-exposed presensitized plate with a warm processing solution, said pre-treatment zone comprising a bath for storing the processing solution and a filter device, the processing solution being filtered by said filter device to remove any solid formed in the processing solution to maintain a water content of not less than 98%, said processing solution being used by circulating through the zone;
a developing zone comprising a bath which stores developing water and has an overflow pipe for draining excess developing water and a pipe for supplying fresh developing water, a water-sprinkling means for supplying the developing water on the plate surface of the presensitized plate treated with the warm processing solution, and a brushing means for rubbing the plate surface with a brush;
a temperature control means for adjusting the temperature of the warm processing solution used in the pre-treatment zone to a desired level ranging from 25 to 70 °C;
ahead of the pre-treatment zone, a zone for peeling off a protective film of the presensitized plate; and
a zone for dyeing the portion of the presensitized plate from which a silicone rubber layer is removed behind the developing zone.

In the following, the term "consisting essentially of water" means that the content of water in a processing solution is not less than 98%. The balance of not more than 2% comprises, in addition to a preservative and a chelating agent, components (such as those included in the light-sensitive and silicone rubber layers of the processed dry PS plate) removed from the dry PS plate and accumulated in the developing water as the development processing proceeds.

It is very effective to increase the temperature of the developing water when a dry PS plate is developed with developing water from the viewpoint of reproduction. This is because the light-sensitive layer on an unexposed area of the dry PS plate must be swollen with water to remove the silicone rubber layer thereon. For this reason, the use of developing water of a high temperature is-effective.

In the present invention, however, the light-sensitive layer on the unexposed area of a dry PS plate is previously swollen by coming the layer into contact with a treating solution consisting essentially of water of a high temperature prior to the removal of the silicone rubber layer thereon. Therefore, the silicone rubber layer can be removed without particularly elevating the temperature of the developing water. Thus, the temperature of the developing water used in the invention may be that of the supply water, but the developing water can of course be warmed prior to use.
Fig. 1 is a diagram showing the pretreating zone of the developing apparatus for practicing the method of the present invention;
Fig. 2 is a diagram showing the pretreating zone of the developing apparatus for practicing the method of the present invention;
Fig. 3 is a cross sectional view showing the schematic structure of an embodiment of the automatic developing machine for practicing the method of the present invention;
Fig. 4 is a cross sectional view showing the schematic structure of an embodiment of the automatic developing machine used in Comparative Example; and
Fig. 5 is a cross sectional view showing the schematic structure of another embodiment of the automatic developing machine for practicing the method of the present invention.

The present invention will hereinafter be explained in more detail.

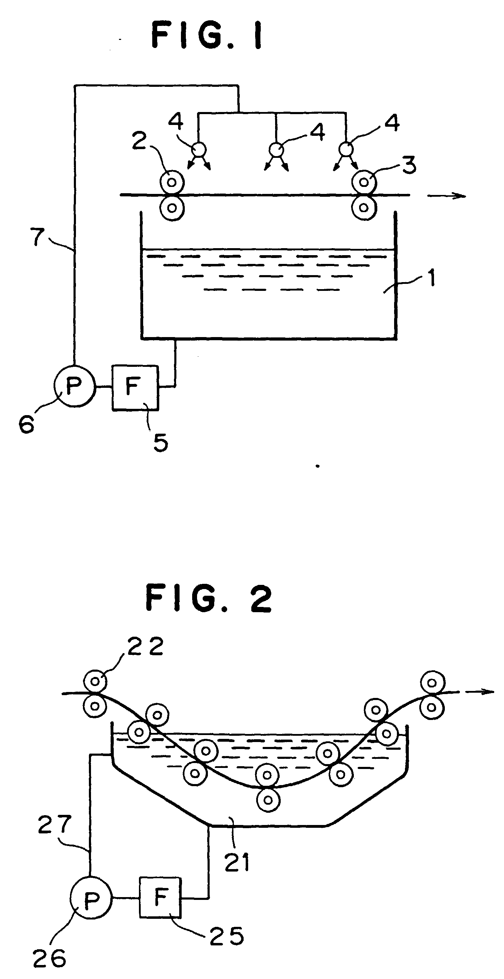

In the pretreating zone of the processing apparatus for practicing the method of the present invention, warmed water may be supplied to the surface of a dry PS plate through a shower spray as shown in Fig. 1 or the dry PS plate may be dipped in a pretreating bath filled with warmed water as shown in Fig. 2.

In Fig. 1, warm water in a warm water bath 1 is pumped up to a spray pipe 4 through a pipe passage 7 by the action of a pump 6 and is sprayed on the surface of the dry PS plate through the spray pipe 4. In this way, the warm water is used by circulating through the pretreating zone. Therefore, if the warm water is once heated to a desired temperature level, only a small quantity of electric power consumption is required for holding this temperature. The circulation permits the agitation of the warm water and correspondingly ensures uniform temperature distribution in the warm water bath and a constant temperature throughout the treatment with the warm water. A filter 5 permits the removal of any solid substances formed in the warm water as the quantity of treated dry PS plates increases and thus serves to protect the pump and prevent any clogging of a spray nozzle. The dipping type pretreating zone shown in Fig. 2 is preferably provided for warm water-circulation system (25, 26, 27) identical to that disdussed above. This results in the removal of solid substances and establishment of a uniform processing temperature during the treatment with warm water, like the spray type treatment shown in Fig. 1.

The temperature of water used in the pretreatment is adjusted to 25 to 70 °C and preferably 30 to 55°C . This is because if the temperature of the water is less than the lower limit, the reproduction of the treatment is impaired, while if it exceeds the upper limit, the treatment is accompanied with a danger and requires the use of a heater having a high capacity which makes the treatment uneconomical.

The pretreating zone is provided with a temperature-control means. to control the temperature of the warm water to the range defined above. The temperature control means may be simply a heater when a temperature is set at a high level (for instance, 40 to 75 °C ), but preferably comprises a combination of a temperature sensor for detecting the temperature of the warm water and a temperature controller for switching (ON/OFF) the heater on the basis of the temperature detected by the sensor. The heater may be arranged at any position in the circulation system so far as it ensures the heating of the warm water. In the pretreating zone as shown in Fig. 1, for instance, the heater can be positioned within the warm water bath 1 or in the middle of the pipe passage which serves to connect the pump 6 to the spray pipe 4, preferably within the warm water bath 1. The temperature sensor may likewise be positioned at any position in the circulation system so far as the temperature of the warm water can be detected.

The pretreating time ranges from 5 to 180 seconds and preferably 10 to 80 seconds.

A part of the water in the warm water bath is reduced through the carry over by dry PS plates processed and evaporation. This reduction of the water may be compensated by supplementing fresh developing water to a desired level prior to the start of the developing machine or alternatively fresh developing water may intermittently be supplemented at regular intervals. Moreover, water may continuously supplemented in a small amount such that the temperature of the warm water is not lowered. The supplementation of water may be manually or automatically be performed. The warm water may be replaced with fresh one at regular intervals prior to the formation of deposits or giving out of a bad smell. A preservative may be added to the warm water bath to eliminate a need for the replacement of water. Further, the dipping water may be purified by a method such as those making use of adsorption (for instance, ion-exchange, removal through active carbon-adsorption), electrodialysis, reverse osmosis (separation by a diaphragm).

Examples of preservatives usable herein are dehydroacetic acid, esters of paraoxybenzoic acid, formalin, salicylic acid, benzoic acid, hydrogen peroxide, hypochlorous acid, bleaching powder, sorbic acid; 4-isothiazoline-3-one compounds, 1,2-benzoisothiazoline-3-one compounds and 2-bromo-2-nitro-1,3-propanediol.

In addition, ozone and ultraviolet rays may likewise be used for the sterilization of water.

Moreover, a chelating agent may be added to the developing water.

In the present invention, there may be used any means for the removal of the silicone rubber layer while sprinkling water on the dry PS plate, such as chemical, physical, electric and mechanical means. This process will herein be referred to as "development".

Examples of mechanical methods include those in which the plate surface is rubbed, for instance, a method comprising rubbing with a roller-like rubbing member, a method comprising rubbing by rotating a plate-like rubbing member, a method comprising rubbing by moving a plate-like rubbing member back and forth and/or left and right or a method comprising rubbing by rotating a roller-like rubbing member or a plate-like rubbing member while moving the member back and forth and/or left and right. In this respect, a plurality of these rubbing members may be used in combination. These rubbing members may be produced from, for instance, brushes, sponges or cloths.

Other examples of methods for rubbing the plate surface include a method comprising blowing high pressure water on the plate surface, a method comprising applying ultrasonic thereto, a method comprising making the dry PS plate vibrate and a method comprising blowing high pressure air thereon.

The removal of the silicone rubber layer by these means may be carried out prior to the supply of developing water, during supplying developing water or after the supply thereof, but preferably carried out prior to or during the supply of developing water to prevent any deposition of the removed silicone rubber onto the plate surface.

Moreover, a plurality of these means for removing the silicone rubber layer may be combined. For instance, the plate surface is first treated by blowing high pressure water thereon and then rubbing the surface with a rotating brush.

The temperature of the developing water may be that of the supplied water. The temperature of well water and tap water in general ranges from 15 to 20°C, but the temperature of water which passes through an exposed piping system in winter is often about 5 °C . In the present invention, water having such a low temperature may be used as the developing water.

The developing water may continuously be supplemented throughout the operation of the developing machine or may intermittently supplemented at regular intervals. The amount thereof to be supplemented when it is continuously carried out preferably ranges from 10 to 10000 ml/min and more preferably 500 to 5000 ml/min.

In addition, the developing zone is preferably provided with a filter within the circulation system in order to remove the scum comprising the silicone rubber removed from the processed dry PS plate.

The developing machine may be equipped with a heater without substantially increasing the size thereof.

The developing apparatus for practicing the developing method of the invention is provided with, ahead of the pretreating zone, a peeling zone for peeling off protective films of dry PS plates processed. Further the apparatus is provided with, behind the developing zone, a dyeing zone for coloring the portions of dry PS plates from which the silicone rubber layer is removed, for the improvement of plate-examination properties. Moreover, a water-washing zone and a drying zone may be disposed behind the dyeing zone and a device for automatically piling up the resulting dry lithographic plates may be arranged.

The dyeing zone and the water-washing zone may be provided with a means for removing silicone rubber such as a rotary brush described above.

To speed up the plate-making process, the developing apparatus may comprise a plurality of developing, dyeing and water-washing zones equipped with means for removing silicone rubber.

The water used in the water-washing zone may be reused in the developing zone and then drained. Alternatively, the water used in the developing zone may be reused in the water-washing zone and then drained.

According to the method of the present invention, a dry PS plate is first brought into contact with warm water consisting essentially of water and having a temperature ranging from 25 to 70 °C and then the silicone rubber thereof is removed while sprinkling developing water consisting essentially of water on the plate surface. Therefore, the use of a heater having a high capacity is not required even if dry PS plates are processed in an automatic developing machine. The method of the invention is thus profitable from the viewpoint of economy and environmental protection. Moreover, a dry lithographic plate which is very excellent in reproduction can be obtained by elevating the temperature of the water for pretreatment.

The present invention will hereinafter be explained in more detail with reference to the following working Examples.

### Example 1

### Dry PS Plate

An aluminum plate of JIS A 1050 having a thickness of 0.3 mm, which had been degreased in the usual manner was immersed in a 1% aqueous solution of KBM® 603 (an aminosilane coupling agent available from Shin-Etsu Chemical Co., Ltd.) and then dried at room temperature. A primer layer having the following composition was applied onto the aluminum plate in an amount of 4 g/m² (weighed after drying) and dried and hardened at 140 °C for 2 minutes.

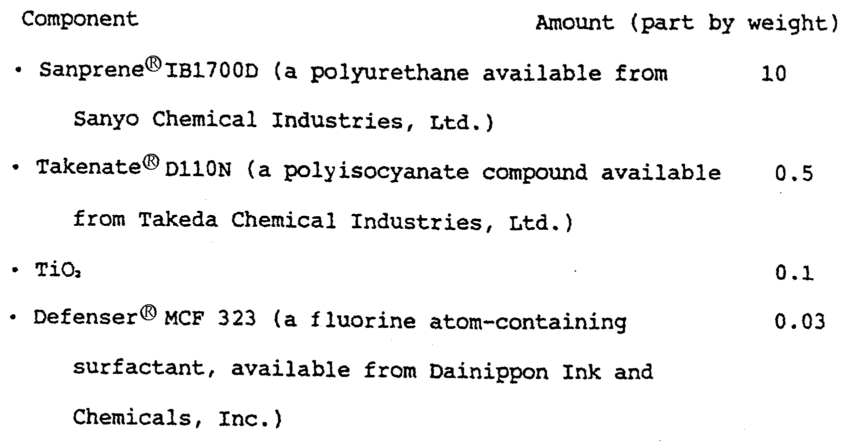

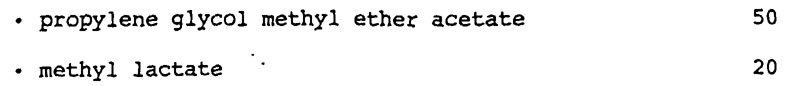

A photopolymerizable light-sensitive solution having the following composition was applied onto the aluminum plate to which the primer layer had been applied in an amount of 5 g/m² (weighed after drying) and dried at 100°C for one minute.

| Component | Amount (part by weight) |
|---|---|
| • Krysbon® 3006LV (a polyurethane, available from Dainippon Ink and Chemicals, Inc.) | 1.5 |
| • A-600® (a polyethylene oxide (n=14) diacrylate available from Shin Nakamura Chemical Co., Ltd.) | 0.8 |
| • xylylenediamine (1 mole)/glycidyl methacrylate (4 moles) adduct | 1.0 |
| • ethyl Michler's ketone | 0.35 |
| • 2-chlorothioxanthone | 0.10 |
| • naphthalene sulfonate of Victoria Pure Blue BOH | 0.01 |
| • Defenser® MCF 323 (a fluorine atom-containing surfactant, available from Dainippon Ink and Chemicals, Inc.) | 0.03 |
| • methyl ethyl ketone | 10 |
| • propylene glycol methyl ether | 20 |

A solution of a silicone rubber composition having the following composition was applied onto the photopolymerizable light-sensitive layer in an amount of 2 g/m² (weighed after drying) and dried at 140 °C for 2 minutes.

| Component | Amount (part by weight) |
|---|---|
| • α , ω-divinylpolydimethylsiloxane (degree of polymerization: about 700) | 9 |
| • (CH₃)₃-Si-O-(Si(CH₃)₂-O)₃₀-(SiH(CH₃)-O)₁₀-Si(CH₃)₃ | 1.2 |
| • polydimethylsiloxane (degree of polymerization: 8000) | 0.5 |
| • olefin-chloroplatinic acid | 0.2 |
| • polymerization inhibitor | 0.3 |
| • Isopar® G (available from ESSO Chemical Company) | 140 |

The silicone rubber layer thus obtained was laminated with a one-side matted biaxially oriented polypropylene film having a thickness of 12 µm so that the non-matted side of the film came in contact with the silicone rubber layer to thus give a dry PS plate. A positive film was put on and brought into close contact with the dry PS plate thus prepared under vacuum, followed by imagewise exposure in the usual exposure machine, peeling off of the laminate film, and development and dyeing at a conveying speed of 60 cm/min using the following developing machine. Thus a dry lithographic plate on which the image of the positive film was faithfully reproduced was obtained.

In this case, a heater of 1.5 KW was disposed only in the pretreating zone and, therefore, the electric capacity of the developing machine was a single-phase voltage of 200 V and a current of 15A inclusive of the electric capacities of the driving motor, the pump and the heater. For this reason, the developing machine could be established by the usual electric installation.

Moreover, the developing machine had continuously been operated to process the dry PS plates over a half year, but it was needed to simply compensate the reduction of the pretreating water and the dyeing solution and the filter in the developing zone was exchanged only one time.

### Developing Apparatus

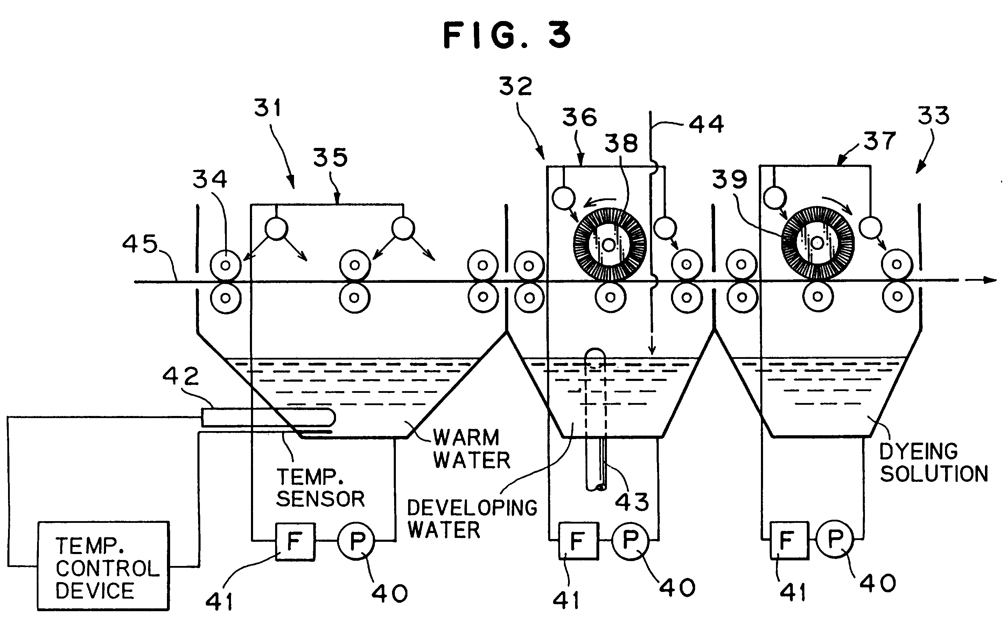

Fig. 3 is a cross sectional view showing the schematic structure of an embodiment of the automatic developing machine for practicing the method of the present invention. In Fig. 3, the reference numeral 31 represents a pretreating zone wherein a dry PS plate is treated with warm water, 32 a developing zone for removing the silicone rubber layer on the image area, 33 a dyeing zone for dyeing the portion of the dry PS plate from which the silicone rubber layer is removed, 34 a conveying roller, 35, 36 and 37 shower pipes, 38 a developing brush roller, 39 a dyeing brush roller, 40 a pump, 41 a filter, 42 a heater, 43 an overflow pipe for draining excess developing water, 44 a tap water pipe for supplying fresh developing water and 45 a dry PS plate.

In the pretreating zone, the processing water was warmed at a temperature of 50 °C by the heater. Moreover, the temperature of the developing water was controlled to 50°C ± 1 °C by a temperature control device. In addition, a trace amount of preservative (5-chloro-2-methyl-4-isothiazoline-3-one. magnesium chloride complex salt) was added to the developing water.

The developing brush and the dyeing brush each was a channel brush roller having an outer diameter of 130 mm which had polybutylene terephthalate (PBT) single yarns having a diameter of 200 µm planted thereon at a bristle length of 17 mm. The polybutylene terephthalate used had a dry tensile strength of 3.0 g/d, a dry tensile elongation of 30.4%, a flexing recovery of 75.7%, a shrinkage factor upon treated with boiling water of 1.7% and a bending stiffness of 3.11 g.

The developing brush was rotated, at a rate of 500 rpm, in the same direction as the travelling direction of the PS plate and simultaneously oscillated at an amplitude of 30 mm at a rate of 120 strokes/min.

The dyeing brush was rotated, at a rate of 300 rpm, in the direction opposite to the travelling direction of the processed dry PS plate and simultaneously oscillated at an amplitude of 30 mm at a rate of 120 strokes/min.

In the developing zone, tap water of 7°C was supplemented at a rate of 2 l/min while the developing water was continuously drained through overflow discharge port during processing the plate. Therefore, the temperature of the developing water was 7 °C, i.e., the temperature identical to that of tap water supplied. The following dyeing solution was introduced into the dyeing zone.

| Dyeing Solution | |
|---|---|
| Component | Amount (part by weight) |
| • Crystal Violet | 0.1 |
| • diethylene glycol monoethyl ether | 15 |
| • pure water | 85 |

### Comparative Example 1

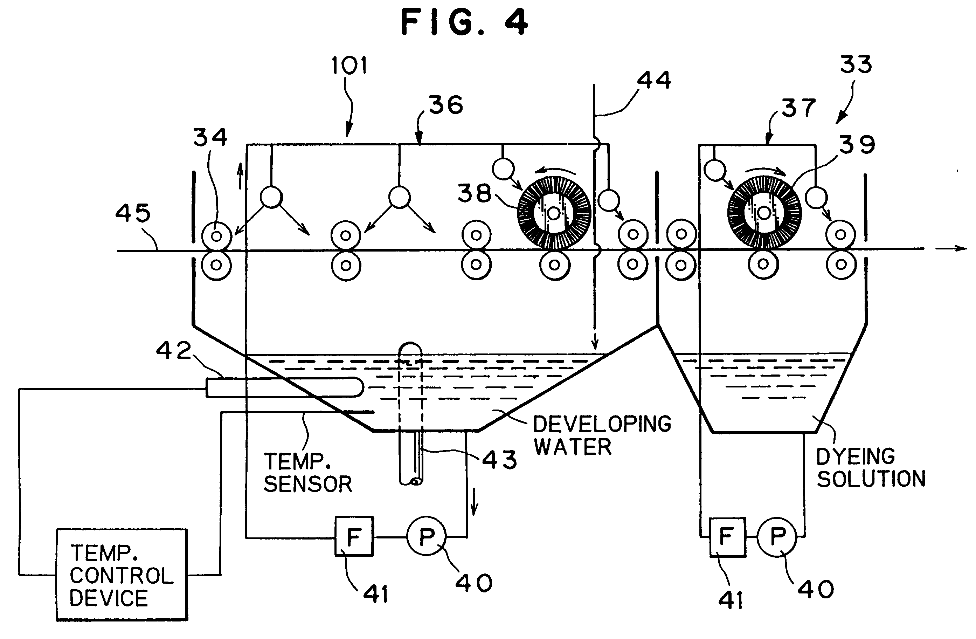

Fig. 4 is a cross sectional view showing the schematic structure of an embodiment of the automatic developing machine used in this Comparative Example. In Fig. 4, the reference numeral 101 represents a developing zone for removing the silicone rubber layer on the image area of a dry PS plate, 33 a dyeing zone for coloring the portion from which the silicone rubber layer is removed, 34 a conveying roller, 36 and 37 shower pipes, 38 a developing brush roller, 39 a dyeing brush roller, 40 a pump, 41 a filter, 42 a heater, 43 an overflow pipe for draining developing water, 44 a tap water pipe for supplying fresh developing water and 45 a dry PS plate.

The developing brush and the dyeing brush are formed from the same polybutylene terephthalate (PBT) single yarns used in Example 1 and used under the same conditions (i.e., the rotational direction, the number of revolutions and the number of oscillations) as those used in Example 1.

The same dyeing solution used in Example 1 was introduced into the dyeing zone.

In the developing zone, the developing water was heated to 50 °C by a heater and controlled to 50 °C ± 1 °C . Moreover, tap water of 7°C was supplemented at a rate of 2 l/min while the developing water was continuously drained through overflow discharge port during processing the plate. This required the use of a heater having a high capacity to maintain the temperature of the developing water to 50°C and, in turn, the electric capacity of this developing machine was a single-phase voltage of 200 V and a current of 60A inclusive of the electric capacities of the driving motor, the pump and the heater. For this reason, the developing machine could not be established by the usual electric installation and accordingly, an improvement work was required.

Further a dry PS plate prepared in the same manner used in Example 1 was developed and dyed at a conveying speed of 60 cm/min and a dry lithographic plate on which the image of the positive film was faithfully reproduced could be obtained.

However, when the supply rate of tap water was increased to 3 l/min, the temperature of the developing water was reduced and the reproduction was impaired.

### Example 2

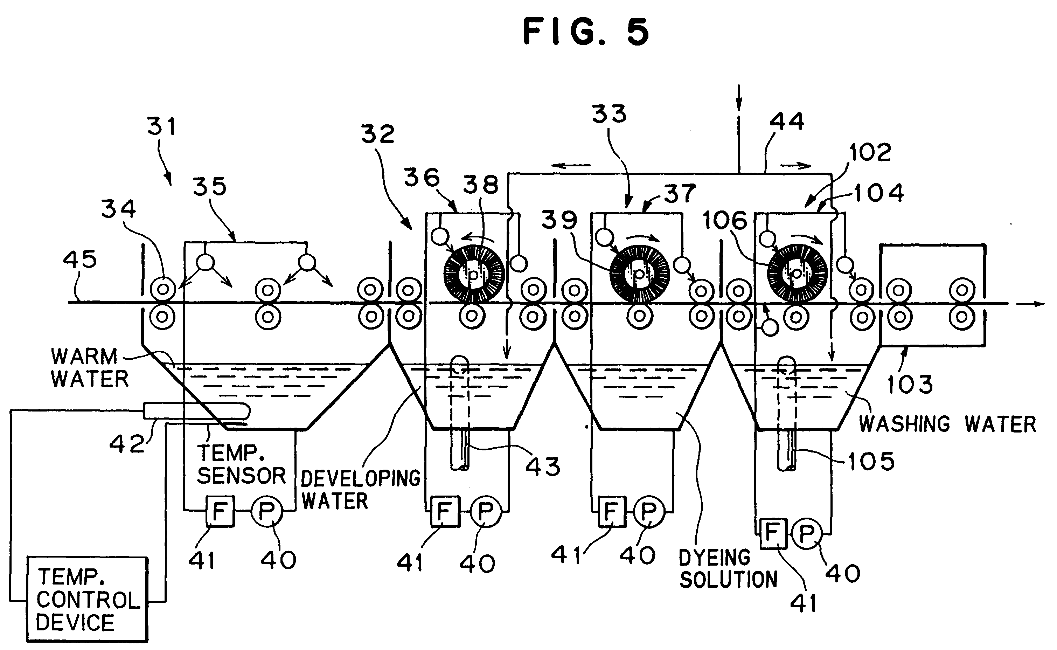

Fig. 5 is a cross sectional view showing the schematic structure of another embodiment of the automatic developing apparatus for practicing the method of the present invention. In Fig. 5, the reference numeral 31 represents a pretreating zone wherein a dry PS plate is treated with warm water, 32 a developing zone for removing the silicone rubber layer on the image area, 33 a dyeing zone for dyeing the portion from which the silicone rubber layer is removed, 103 a drying zone for drying the dry PS plate, 34 a conveying roller, 35, 36, 37 and 104 shower pipes, 38 a developing brush roller, 39 a dyeing brush roller, 106 a water-washing brush roller, 40 a pump, 41 a filter, 42 a heater, 43 an overflow pipe for draining developing water, 105 a overflow pipe for draining washing water, 44 a tap water pipe for supplying fresh developing water and washing-water and 45 a dry PS plate.

In the pretreating zone, the processing water was warmed at a temperature of 50 °C by the heater. Moreover, the temperature of the developing water was controlled to 50°C ± 1 °C by a temperature control device. In addition, a trace amount of preservative (5-chloro-2-methyl-4-isothiazoline-3-one-magnesium chloride complex salt) was added to the developing water.

The developing brush, the dyeing brush and the water-washing brush were formed from the same polybutylene terephthalate (PBT) single yarns used in Example 1 and the developing and dyeing brushes were used under the same conditions (i.e., the rotational direction, the number of revolutions and the number of oscillations) as those used in Example 1. The water-washing brush was rotated, at a rate of 300 rpm, in the direction opposite to the travelling direction of the processed dry PS plate and simultaneously oscillated at an amplitude of 30 mm at a rate of 120 strokes/min.

In the developing zone and the water-washing zone, tap water of 17°C was supplemented at a rate of 2 l/min while the developing water and the washing water were continuously drained through overflow discharge ports during processing the plate. Therefore, the temperature of the developing water and the washing water was 17 °C, i.e., the temperature identical to that of tap water supplied.

In this case, a heater of 1.5 KW was disposed in the pretreating zone and, therefore, the electric capacity of the developing machine was a single-phase voltage of 200 V and a current of 20A inclusive of the electric capacities of the driving motor, the pump and the heaters for the pretreating and drying zones. For this reason, the developing machine could be established by the usual electric installation.

The same dyeing solution used in Example 1 was introduced into the dyeing zone.

Further a dry PS plate prepared in the same manner used in Example 1 was developed and dyed at a conveying speed of 100 cm/min and a dry lithographic plate on which the image of the positive film was faithfully reproduced could be obtained.

## Claims

1. A method for making a lithographic printing plate requiring no dampening water using an automatic developing machine, said method comprising the steps of pre-treating an image-wise exposed presensitized plate for use in making a lithographic printing plate requiring no dampening water in a pre-treatment zone using a warm processing solution of from 25 to 70°C stored and circulated in said zone and filtered to remove any solid formed in the warm processing solution to maintain a water content of not less than 98%, and then removing the silicone rubber while sprinkling a developer having a water content of not less than 98%.

2. The method of claim 1 wherein the temperature of the processing solution used in the pre-treatment ranges from 30 to 55 °C.

3. The method of claim 1 wherein a trace amount of a preservative is added to the processing solution used in the pre-treatment.

4. The method of claim 1 wherein the developer is continuously supplemented throughout the developing operation at a rate ranging from 10 to 10000 ml/min or intermittently supplemented at regular intervals.

5. The method of claim 1 wherein the temperature of the developer is equal to that of the processing solution supplied.

6. A plate-making apparatus for developing an imagewise-exposed presensitized plate for use in making a lithographic printing plate requiring no dampening water which comprises:
a pre-treatment zone for pre-treating the imagewise-exposed presensitized plate with a warm processing solution, said pre-treatment zone comprising a bath for storing the processing solution and a filter device, the processing solution being filtered by said filter device to remove any solid formed in the processing solution to maintain a water content of not less than 98%, said processing solution being used by circulating through the zone;
a developing zone comprising a bath which stores developing water and has an overflow pipe for draining excess developing water and a pipe for supplying fresh developing water, a water-sprinkling means for supplying the developing water on the plate surface of the presensitized plate treated with the warm processing solution, and a brushing means for rubbing the plate surface with a brush;
a temperature control means for adjusting the temperature of the warm processing solution used in the pre-treatment zone to a desired level ranging from 25 to 70 °C;
ahead of the pre-treatment zone, a zone for peeling off a protective film of the presensitized plate; and
a zone for dyeing the portion of the presensitized plate from which a silicone rubber layer is removed behind the developing zone.

7. The plate-making apparatus of claim 6 wherein the temperature control means comprises a temperature sensor for detecting the temperature of the warm processing solution and a temperature controller for switching a heater on the basis of the temperature detected by the sensor.

8. The plate-making apparatus of claim 6 wherein a heater is positioned in a warm water bath.

9. The plate-making apparatus of claim 6 which further comprises a water-washing zone and a drying zone behind the dyeing zone.

## Patentansprüche

1. Verfahren zum Herstellen einer lithographischen Druckplatte, die kein Befeuchtungswasser erfordert, das eine automatische Entwicklungsmaschine verwendet, wobei das Verfahren die Schritte einer Vorbehandlung einer abbildungsweise belichteten, vorsensibilisierten Platte zur Verwendung beim Herstellen einer lithographischen Druckplatte, die kein Befeuchtungswasser in einer Vorbehandlungszone erfordert, Verwenden einer warmen Behandlungslösung von 25 bis 70°C, die in der Zone bevorratet ist und zirkuliert wird und gefiltert wird, um irgendwelche Feststoffe zu entfernen, die in der warmen Behandlungslösung gebildet sind, um einen Wassergehalt nicht weniger als 98% beizubehalten, und dann Entfernen des Silikongummis während eines Besprenkelns einer Entwicklungseinrichtung, die einen Wassergehalt von nicht weniger 98% besitzt, aufweist.

2. Verfahren nach Anspruch 1, wobei die Temperatur der Behandlungslösung, die in den Vorbehandlungsbereichen verwendet ist, von 30 bis 55 °C reicht.

3. Verfahren nach Anspruch 1, wobei eine Spur eines Präventionsmittels zu der Behandlungslösung hinzugefügt wird, die in der Vorbehandlung verwendet ist.

4. Verfahren nach Anspruch 1, wobei der Entwickler kontinuierlich während des gesamten Entwicklungsvorgangs unter einer Rate nachgefüllt wird, die von 10 bis 10000 ml/min reicht, oder intermittierend unter regelmäßigen Intervallen nachgefüllt wird.

5. Verfahren nach Anspruch 1, wobei die Temperatur des Entwicklers gleich zu derjenigen der Behandlungslösung, die zugeführt ist, ist.

6. Plattenherstellgerät zum Entwickeln einer abbildungsweise belichteten, vorsensibilisierten Platte zur Verwendung bei der Herstellung einer lithographischen Druckplatte, die kein Befeuchtungswasser erfordert, das aufweist:
eine Vorbehandlungszone zur Vorbehandlung der abbildungsweise belichteten, vorsensibilisierten Platte mit einer warmen Behandlungslösung, wobei die Vorbehandlungszone ein Bad zum Bevorraten der Behandlungslösung und eine Filtereinrichtung aufweist, wobei die Behandlungslösung durch die Filtereinrichtung gefiltert wird, um irgendwelchen Feststoff, der in der Behandlungslösung gebildet ist, zu entfernen, um einen Wassergehalt von nicht weniger als 98% beizubehalten, wobei die Behandlungslösung unter Zirkulation durch die Zone verwendet wird;
eine Entwicklungszone, die ein Bad, das Entwicklungswasser bevorratet und ein Überlaufrohr zum Ablassen überflüssigen Entwicklungswassers, und ein Rohr zum Zuführen von frischem Entwicklungswasser, eine Wasserbesprenkelungseinrichtung zum Zuführen des Entwicklungswassers auf die Plattenoberfläche der vorsensibilisierten Platte, die mit der warmen Behandlungslösung behandelt ist, und eine Bürsteneinrichtung zum Abreiben der Plattenoberfläche mit einer Bürste, aufweist;
eine Temperaturregeleinrichtung zum Einstellen der Temperatur der warmen Behandlungslösung, die in der Vorbehandlungszone verwendet wird, auf ein vorbestimmtes Niveau, das von 25 bis 70°C reicht;
vor der Vorbehandlungszone eine Zone zum Abschälen eines Schutzfilms der vorsensibilisierten Platte; und
eine Zone zum Färben des Bereichs der vorsensibilisierten Platte, von der eine Silikongummischicht entfernt ist, hinter der Entwicklungszone.

7. Plattenherstellgerät nach Anspruch 6, wobei die Temperaturregeleinrichtung einen Temperatursensor zum Erfassen der Temperatur der warmen Behandlungslösung und eine Temperaturregeleinrichtung zum Umschalten einer Heizeinrichtung auf der Basis der Temperatur, die durch den Sensor erfaßt ist, aufweist.

8. Plattenherstellgerät nach Anspruch 6, wobei eine Heizeinrichtung in einem Warmwasserbad positioniert ist.

9. Plattenherstellgerät nach Anspruch 6, das weiterhin eine Wasserwaschzone und eine Trockenzone hinter der Färbezone aufweist.

## Revendications

1. Méthode de fabrication d'une plaque d'impression lithographique ne nécessitant pas de mouillage à l'eau à l'aide d'une machine de développement automatique, ladite méthode comprenant les étapes de pré-traitement d'une plaque pré-sensibilisée, exposée à la façon d'une image, utile dans la fabrication d'une plaque d'impression lithographique ne nécessitant pas de mouillage à l'eau, dans une zone de pré-traitement utilisant une solution de traitement tiède entre 25 et 70°C conservée et circulant dans ladite zone et filtrée pour éliminer tous les solides formés dans la solution de traitement tiède afin de maintenir la concentration en eau à une valeur qui ne soit pas inférieure à 98 % et ensuite d'élimination du caoutchouc de silicone pendant l'aspersion par un développateur ayant une concentration en eau qui n'est pas inférieure à 98 %.

2. Méthode selon la revendication 1, dans laquelle la température de la solution de traitement utilisée dans le pré-traitement se situe entre 30 et 55°C.

3. Méthode la revendication 1, dans laquelle une trace d'un conservateur est ajoutée à la solution de traitement utilisée dans le pré-traitement.

4. Méthode selon la revendication 1, dans laquelle le développateur est ajouté en continu tout au long de l'opération de développement à une vitesse allant de 10 à 10 000 ml/mn ou est ajouté par intermittence à des intervalles réguliers.

5. Méthode selon la revendication 1, dans laquelle la température du développateur est égale à celle de la solution de traitement ajoutée.

6. Appareil de fabrication d'une plaque pour le développement d'une plaque pré-sensibilisée exposée à la façon d'une image, utile pour la fabrication d'une plaque d'impression lithographique ne nécessitant pas de mouillage à l'eau, comprenant :
une zone de pré-traitement pour le pré-traitement de la plaque pré-sensibilisée exposée à la façon d'une image par une solution de traitement tiède, ladite zone de pré-traitement comprenant un bain pour la conservation de la solution de traitement et un dispositif filtrant, la solution de traitement étant filtrée par ledit dispositif filtrant pour éliminer tous les solides formés dans la solution de traitement et maintenir la concentration en eau à une valeur qui ne soit pas inférieure à 98 %, ladite solution de traitement étant utilisée par circulation dans la zone ;
une zone de développement comprenant un bain pour la conservation de l'eau de développement et ayant un trop-plein pour évacuer l'eau de développement en excès et une canalisation pour l'alimentation en eau de développement fraîche, un moyen d'aspersion par de l'eau pour apporter l'eau de développement au niveau de la surface de la plaque de la plaque pré-sensibilisée traitée par la solution de traitement tiède et un moyen de brossage pour frotter la surface de la plaque avec une brosse ; un moyen de contrôle de la température pour ajuster la température de la solution de traitement tiède utilisée dans la zone de pré-traitement dans l'intervalle souhaité allant de 25 à 70° C ;
en avant de la zone de pré-traitement, une zone pour détacher le film protecteur de la plaque pré-sensibilisée ; et
une zone de coloration de la partie de la plaque pré-sensibilisée dont la couche en caoutchouc de silicone a été enlevée derrière la zone de développement.

7. Appareil de fabrication d'une plaque selon la revendication 6, dans lequel le moyen de contrôle de la température comprend un capteur de température pour détecter la température de la solution de traitement tiède et un dispositif de commande de la température qui actionne un dispositif de chauffage en fonction de la température détectée par le capteur.

8. Appareil de fabrication d'une plaque selon la revendication 6, dans lequel un dispositif de chauffage est situé dans un bain marie tiède.

9. Appareil de fabrication d'une plaque selon la revendication 6, qui contient en outre une zone de lavage à l'eau et une zone de séchage derrière la zone de coloration.
